# EUROPEAN PATENT APPLICATION

(11) **EP 4 827 255 A1**
(43) Date of publication of application: **21.10.2026**
(21) Application number: 24964108.5
(22) Date of filing: 19.12.2024
(51) Int. Cl.: H05K 7/20

(54) **ELECTRONIC CONTROL UNIT**

(71) Applicant: LG Electronics Inc., Yeongdeungpo-gu Seoul 07336 (KR)
(72) Inventor: YUN, Donghwa, Seoul 06772 (KR)
(74) Representative: Vossius & Partner Patentanwälte Rechtsanwälte mbB
(86) International application number: PCT/KR2024/020727
(87) International publication number: WO 2026/134378

(57) **Abstract**

An electronic control unit comprises a housing; a cooling jacket disposed in the housing; and a first board having a first semiconductor element mounted on the first board, the first semiconductor element being in thermal contact with at least one of the housing and the cooling jacket. The housing comprising a housing body in thermal contact with the first board and having a first space formed in the housing body; and a heat dissipation member configured to cover the first space and having heat dissipation fins formed on the heat dissipation member, wherein a first phase change material is contained in the first space.

## Description

### [Technical Field]

The present disclosure relates to an electronic control unit.

### [Background Art]

Assemblies installed in a vehicle include an engine control assembly (or motor control assembly), a power transmission assembly, a brake assembly, a suspension assembly, a steering assembly, an instrument assembly, and an information and communication control assembly.

An electronic control unit (ECU) is a control device that controls and manages these major vehicle assemblies, a plurality of ECUs installed in a vehicle, depending on the assembly, control each assembly.

The ECU may include an ECU embedded with a chip for autonomous driving or in-vehicle infotainment (software or media that adds entertainment to the transmission of information), it is desirable for such an ECU to properly cool the chip or the substrate control board on which the chip is installed to prevent overheating of the chip.

An example of an electronic control unit that is cooled is disclosed in U.S. Patent Publication No. US 5,323,292 A registered on June 21, 1994, which discloses an electronic module comprising an aluminum heat sink surrounding an integrated circuit chip and a substrate, the heat sink including parallel fins that provide a large surface area for dissipating heat into the surrounding atmosphere.

### [Disclosure]

### [Technical Problem]

The present invention provides an electronic control unit in which a semiconductor element can efficiently dissipate heat using a cooling jacket and a phase change material.

The present invention provides an electronic control unit in which the phase change material can efficiently dissipate heat from the semiconductor element even when the coolant temperature is high.

### [Technical Solution]

An electronic control unit according to the present embodiment may comprise may comprise a housing; a cooling jacket disposed in the housing; and a first board having a first semiconductor element mounted on the first board, the first semiconductor element being in thermal contact with at least one of the housing or the cooling jacket.

The housing may comprise a housing body in thermal contact with the first board and having a first space formed in the housing body; and a heat dissipation member configured to cover the first space and having heat dissipation fins formed on the heat dissipation member.

A first phase change material may be contained in the first space.

The housing may comprise a lower housing; and an upper housing disposed above the lower frame, the upper housing may comprise the housing body and the heat dissipation member.

The electronic control unit may further comprise a fastening member penetrating the first board and fastened to the housing body; and a spring disposed between the fastening member and the first board and configured to press the first board to the housing.

The electronic control unit may further comprise a sealer disposed between the housing body and the heat dissipation member.

The electronic control unit may further comprise a fastening member configured to fasten the heat dissipation member, the sealer, and the housing body.

The first semiconductor element of one example of the electronic control unit may be in thermal contact with an upper surface of the cooling jacket.

One example of the electronic control unit may further comprise a second board having a second semiconductor element mounted on the second board; the second semiconductor element in thermal contact with a lower surface of the cooling jacket; and a third board having a third semiconductor element mounted on the third board; the third semiconductor element in thermal contact with the lower surface of the cooling jacket.

The cooling jacket of one example of the electronic control unit may comprises: a coolant passage through which coolant flows; a second space partitioned from the coolant passage; and a third space partitioned from the coolant passage and the second space, a second phase change material is contained in the second space, and a third phase change material is contained in the third space.

The cooling jacket of one example of the electronic control unit may comprise a coolant cover; a cooling plate disposed below the coolant cover; and a lower cover disposed below the cooling plate.

The coolant passage may be formed between the coolant cover and the cooling plate.

The second space and the third space may be formed on a bottom surface of the cooling plate.

The lower cover may cover the second space and the third space.

The second semiconductor element and the third semiconductor element may be in thermal contact with the lower cover.

One example of the electronic control unit may further comprise a valve for closing or opening the coolant passage; and a controller configured to control the valve.

The first semiconductor element may comprise a first temperature sensor.

The second semiconductor element may comprise a second temperature sensor.

The third semiconductor element may comprise a third temperature sensor.

The controller may close or open the valve based on a sensing values of the first temperature sensor, a sensing values of the second temperature sensor, and a sensing values of the third temperature sensor.

The cooling jacket of the other example of the electronic control unit may comprise a lower coolant jacket having a first passage and a second passage spaced apart from the first passage, and a lower coolant passage formed between the first and second passages through which coolant passes; and an upper coolant jacket having a third passage communicating with the second passage and a fourth passage spaced apart from the third passage, and an upper coolant passage formed between the third and fourth passages through which coolant passes.

The housing of the other example of the electronic control unit may be disposed on a lower surface of the lower coolant jacket or on an upper surface of the upper coolant jacket.

The other example of the electronic control unit may comprise a control board disposed between the lower coolant jacket and the upper coolant jacket.

The housing of other example of the electronic control unit may comprise a lower housing; and an upper housing disposed above the lower housing, the first semiconductor element may be in thermal contact with one of the lower housing and the upper housing, and the first board may be in thermal contact with the other of the lower housing and the upper housing.

### [Advantageous Effect]

According to the present embodiment, the first semiconductor element and the first board can be efficiently heat-dissipated by the cooling jacket and the first phase-change material.

Furthermore, heat transferred to the first phase change material can be transferred to a heat dissipation member and then air-cooled.

Furthermore, heat transferred to the heat dissipation member can be minimized from being transferred to the housing body, and heat generation of the housing body can be prevented.

Furthermore, a fastening member can fasten the heat dissipation member, the sealer, and the housing body, thereby minimizing the number of components.

Furthermore, the first semiconductor element is in thermal contact with the upper surface of the cooling jacket, so that heat from the first semiconductor element can be efficiently dissipated by the cooling jacket.

Furthermore, the cooling jacket can simultaneously dissipate heat from the first semiconductor element mounted on the first board, the second semiconductor element mounted on the second board, and the third semiconductor element mounted on the third board, thereby minimizing the number of cooling jackets.

Furthermore, since the second phase change material, which absorbs heat from the second semiconductor element, and the third phase change material, which absorbs heat from the third semiconductor element, are accommodated in the cooling jacket, the number of components can be minimized, and the structure is simple.

Furthermore, a coolant passage is formed between the coolant cover and the cooling plate, and a second space and a third space are formed between the cooling plate and the lower cover, so that the second semiconductor element and the third semiconductor element can dissipate heat by the coolant passing through the cooling jacket, or by the second phase change material accommodated in the second space and the third phase change material accommodated in the third space.

Furthermore, since the heat from the second semiconductor element and the third semiconductor element can be transferred to the coolant through the lower cover and the cooling plate, the number of components can be minimized.

Furthermore, the valve closes or opens the coolant passage, and the controller controls the valve to block high-temperature coolant from flowing into the coolant passage, thereby minimizing temperature rise of the first, second, or third semiconductor elements due to the high-temperature coolant.

Furthermore, when the coolant is high-temperature, the coolant does not flow into the coolant passage, and the heat of the first semiconductor element is transferred to the first phase change material, the heat of the second semiconductor element is transferred to the second phase-change material, and the heat of the third semiconductor element is transferred to the third phase-change material, thereby improving the reliability of the electronic control unit.

Furthermore, the cooling jacket includes a lower coolant jacket and an upper coolant jacket, and the control board is positioned between the lower coolant jacket and the upper coolant jacket, such that heat from the control board can be distributed and transferred to the lower coolant jacket and the upper coolant jacket, and the control board can be quickly dissipated.

### [Description of Drawings]

Fig. 1 is a perspective view of an example of an electronic control unit according to the present embodiment,
Fig. 2 is a view illustrating the interior of an example of an electronic control unit according to the present embodiment,
Fig. 3 is an exploded perspective view of an example of an electronic control unit according to the present embodiment,
Fig. 4 is a view illustrating an example of an electronic control unit according to the present embodiment when cooled by a water-cooling loop system,
Fig. 5 is a control block view of an example of an electronic control unit according to the present embodiment,
Fig. 6 is a flow chart of an example of an electronic control unit according to the present embodiment,
Fig. 7 is a perspective view of the other example of an electronic control unit according to the present embodiment,
Fig. 8 is a view illustrating the interior of the other example of an electronic control unit according to the present embodiment,
Fig. 9 is a view illustrating an example of an electronic control unit according to the present embodiment when cooled by a water-cooling loop system,
Fig. 10 is a control block view of the other example of an electronic control unit according to the present embodiment,
Fig. 11 is a view illustrating a flow chart of the other example of an electronic control unit according to the present embodiment.

### [Best Mode]

Hereinafter, specific embodiments of the present disclosure will be described in detail with reference to the drawings.

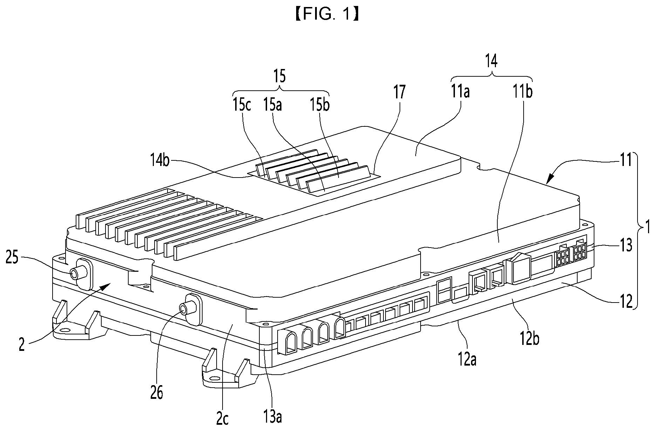

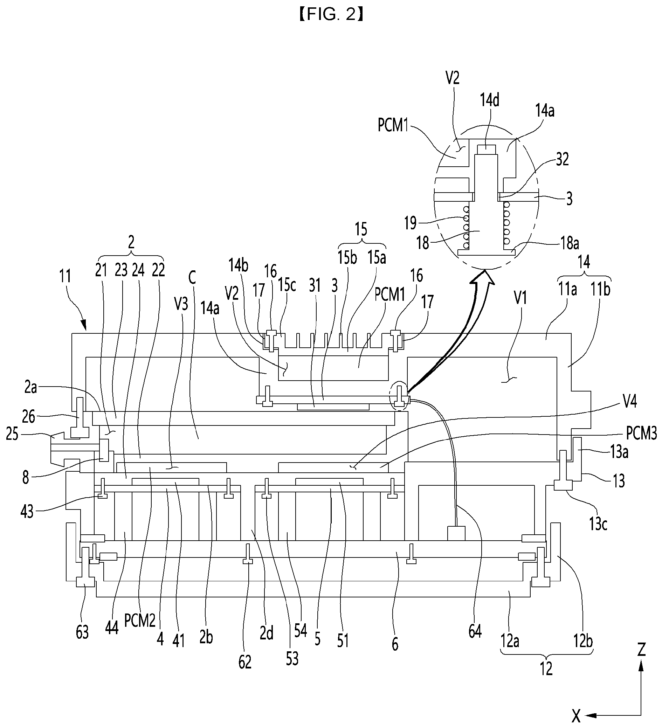

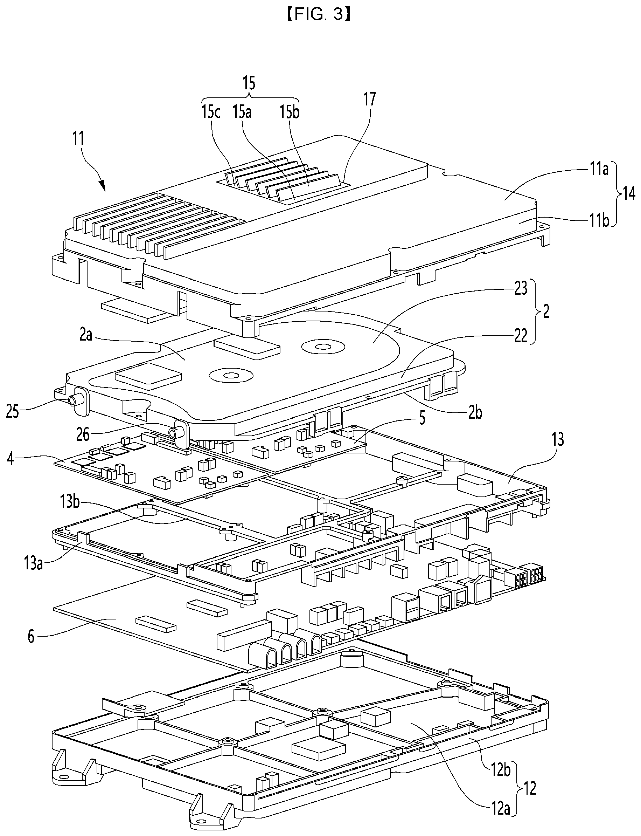

Fig. 1 is a perspective view of an example of an electronic control unit according to the present embodiment, Fig. 2 is a view illustrating the interior of an example of an electronic control unit according to the present embodiment, and Fig. 3 is an exploded perspective view of an example of an electronic control unit according to the present embodiment.

An example of an electronic control unit according to the present embodiment may include a housing 1, a cooling jacket 2, and a first board 3.

The housing 1 may form the exterior of the electronic control unit.

An inner space V1 may be formed within the housing 1. Various components constituting the electronic control unit may be accommodated in the inner space V1.

The cooling jacket 2, the first board 3, and the like may be accommodated in the inner space V1 and protected by the housing 1.

The housing 1 may be composed of a combination of multiple members.

The housing 1 may include an upper housing 11 and a lower housing 12.

The upper housing 11 may be disposed above the lower housing 12.

The upper housing 11 may form the upper surface of the electronic control unit. A space may be formed within the upper housing 11. The bottom of the upper housing 11 may be open.

The upper housing 11 may comprise an upper body 11a and a peripheral body 11b protruding from the edge of the upper body 11a.

Heat from the first board 3 may be transferred to the upper housing 11, and the upper housing 11 may dissipate heat transferred from the first board 3 to the upper housing 11 to the outside.

The upper housing 11 may be made of aluminum and may function as a heat sink.

The lower housing 12 may form the lower exterior of the electronic control unit. A space may be formed within the lower housing 12. The upper surface of the lower housing 12 may be open.

The lower housing 12 may comprise a lower body 12a and a peripheral body 12b protruding from the edge of the lower body 12a.

The lower housing 12 may be made of aluminum and may function as a heat sink.

An example of a housing 1 may comprise an upper housing 11 and a lower housing 12, and may further include a frame 13 disposed between the upper housing 11 and the lower housing 12.

An example of the frame 13 may be a middle frame disposed between the upper housing 11 and the lower housing 12.

The frame 13 may comprise a peripheral body 13a.

An example of the peripheral body 13a may be disposed between the peripheral body 11b of the upper housing 11 and the peripheral body 12b of the lower housing 12, or between the peripheral body 2c of the cooling jacket 2 and the peripheral body 12b of the lower housing 12, the peripheral body 13a may form the peripheral surface of the electronic control unit.

The other example of the frame 13 may be accommodated in the inner space S, surrounded by the upper housing 11 or the lower housing 12, and concealed by the upper housing 11 or the lower housing 12.

A mounting body 13b on which a cooling jacket 2 is mounted may be formed on the frame 13, and the frame 13 may support the cooling jacket 2.

The frame 13 may be fastened to the upper housing 11 from the lower side of the upper housing 11. The frame 13 may be fastened to the upper housing 11 by a fastening member 13c such as a screw or a hook.

The other example of the housing 1 may not further include the frame 13, but may include the upper housing 11 and the lower housing 12. When the other example of the housing 1 includes the upper housing 11 and the lower housing 12, the upper housing 11 and the lower housing 12 may be fastened by a fastening member such as a screw or a hook.

The cooling jacket 2 may be disposed on the housing 1. The cooling jacket 2 may be disposed outside the housing 1 or inside the housing 1.

An example of the cooling jacket 2 may be accommodated in the inner space S and protected by the housing 1.

A coolant passage 21 through which a coolant, such as water, passes may be formed inside the cooling jacket 2.

The cooling jacket 2 may comprise a cooling plate 22, a coolant cover 23 disposed above the cooling plate 22, and a lower cover 24 disposed below the cooling plate 22.

The upper surface of the cooling plate 22 may face the coolant cover 23. The coolant passage 21 may be formed between the coolant cover 23 and the cooling plate 22. The coolant passage 21 may be formed inside the cooling plate 22.

The lower surface of the cooling plate 22 may face the lower cover 24.

The upper surface of the coolant cover 23 may be the upper surface 2a of the cooling jacket 2.

The coolant cover 23 may cover the coolant passage 21 from the upper side of the coolant passage 21.

The lower surface of the lower cover 24 may be the lower surface 2b of the cooling jacket 2.

The upper surface 2a of the cooling jacket 2 and the lower surface 2b of the cooling jacket 2 may each be a heat-absorbing surface that absorbs heat from the semiconductor element.

The cooling jacket 2 may include a peripheral body 2c exposed to the outside.

The cooling plate 22 may form the peripheral body 2c of the cooling jacket 2.

A cooling jacket 2 may be formed with a coolant inlet 25 that guides coolant to a coolant passage 21. The coolant inlet 25 may be arranged to protrude from one side of the cooling jacket 2. The coolant inlet 25 may be formed to protrude from the peripheral body 2c of the cooling jacket 2.

A coolant outlet 26 that guides coolant that has passed through the coolant passage 21 may be formed from the cooling jacket 2. The coolant outlet 26 may be arranged to protrude from one side of the cooling jacket 2. The coolant outlet 26 may be formed to protrude from the peripheral body 2c of the cooling jacket 2. The coolant outlet 26 may be formed parallel to the coolant inlet 25.

At least one of the cooling jacket 2 and the frame 13 may be fastened to the upper housing 11 using a fastening member 27, such as a screw.

A first board 3 may be disposed between the upper housing 1 and the cooling jacket 2.

A first semiconductor element 31 may be mounted on the first board 3. The first semiconductor element 31 may be mounted on the lower surface of the first board 3.

The first semiconductor element 51 may be in thermal contact with the upper surface 2a of the cooling jacket 2, and heat from the first semiconductor element 51 may be transferred to the upper surface 2a of the cooling jacket 2.

An example of the first semiconductor element 31 may be a system-on-chip (SoC) mounted on the first board 5.

An example of the first semiconductor element 31 may be a semiconductor chip that performs autonomous driving of a vehicle.

An example of the first semiconductor element 31 may be a neural network processing unit.

If the first semiconductor element 31 is the neural network processing unit, the heat generated by the first semiconductor element 31 may be high during operation.

It is preferable that the cooling jacket 2 balance the heat transfer between its upper surface 2a and lower surface 2b.

The first board 3 and the first semiconductor element 31 may be disposed between the cooling jacket 2 and the upper housing 11. The first board 3 and the first semiconductor element 31 may be cooled by the cooling jacket 2 and the upper housing 11 in a double-sided cooling manner.

The first semiconductor element 31 may be in thermal contact with the upper surface 2a of the cooling jacket 2 and is preferably heat-radiated by coolant passing through the cooling jacket 2, the first board 3 may be in thermal contact with the upper housing 11 and is preferably heat-radiated by the upper housing 11.

One example of the first semiconductor element 31 may be in direct contact with the upper surface 2a of the cooling jacket 2.

The other example of the first semiconductor element 31 may be in contact with the upper surface 2a of the cooling jacket 2 via a first thermal interface material. The first thermal interface material may be disposed between the lower surface of the first semiconductor element 31 and the upper surface 2a of the cooling jacket 2.

The upper housing 11 may be in contact with the upper surface of the first board 3.

The upper housing 11 preferably dissipates heat from the first board 3 using air cooling.

The upper housing 11 may comprise a housing body 14 and a heat dissipation member 15.

The housing body 14 may comprise an upper body 11a and a peripheral body 11b.

A first space V2 may be formed in the housing body 14. The first space V2 may be partitioned from an inner space V1 by the housing body 14.

The housing body 14 may comprise a receiving body 14a. The receiving body 14a may be formed to protrude downward from the upper body 11a. The outer peripheral surface of the receiving body 14a may be spaced apart from the peripheral body 11b.

The receiving body 14a may have an open upper surface. The peripheral surface and lower surface of the receiving body 14a may each be closed. A first space S1 may be formed within the receiving body 14a.

The housing body 14 may have a stepped groove 14b into which a fastening body 15c of a heat dissipation member 15 is inserted and received. The stepped groove 14b may be formed to be recessed downward in the upper body 11a.

A first phase change material PCM1 may be received in the first space S1. The first phase change material PCM1 may be received in the receiving body 14a.

The first phase change material PCM1 may be a material that accumulates a large amount of thermal energy or releases stored thermal energy through a phase change process.

The first phase change material PCM1 reaches its melting point when the temperature rises, and may absorb a certain amount of heat known as the enthalpy of melting as it changes phase from a solid state to a liquid state.

The heat of the first board 3 may be transferred to the first phase change material PCM1 through the receiving body 14a, and the first phase change material PCM1 may change phase from a solid state to a liquid state due to the heat transferred from the first board 3 and may absorb heat released from the first board 3.

The first phase change material PCM1 can release heat as it changes from a liquid state to a solid state. The heat released from the first phase change material PCM1 may be transferred to a heat dissipation member 15, which can dissipate the transferred heat to the outside of the electronic control unit.

The heat dissipation member 15 may be a heat sink that dissipates heat to the outside of the electronic control unit. The heat dissipation member 15 may be made of aluminum.

The heat dissipation member 15 may be disposed on a surface of the electronic control unit that is exposed to the outside. The heat dissipation member 15 can dissipate heat using air cooling.

The heat dissipation member 15 may include a heat dissipation plate 15a that covers the first space S1. The heat dissipation plate 15a may cover the first space S1 from an upper side of the first space S1.

Heat from the first phase change material PCM1 can be transferred to a heat dissipation plate 15a.

The heat dissipation member 15 may comprise a plurality of heat dissipation fins 15b. The plurality of heat dissipation fins 15b may be formed on the heat dissipation plate 15b. The plurality of heat dissipation fins 15a may be parallel to each other. The heat from the heat dissipation plate 15a may be conducted to the plurality of heat dissipation fins 15b, and the plurality of heat dissipation fins 15b may dissipate the heat transferred from the heat dissipation plate 15a in an air-cooled manner.

The heat dissipation member 15 may further comprise a fastening body 15c fastened to the housing body 14. The fastening body 15c may be inserted into a stepped groove 14b of the housing body 14 from an upper side of the housing body 14.

The heat dissipation member 15 may be fastened to the housing body 14 using a fastening member 16 such as a screw.

The fastening member 16 may pass through a through hole formed in the fastening body 15c and be fastened to a fastening hole formed in the housing body 14.

The electronic control unit may further include a sealer 17 disposed between the housing body 14 and the heat dissipation member 15.

The sealer 17 can adhere the heat dissipation member 15 to the housing body 14. The sealer 17 can function as an adhesive.

The sealer 17 can prevent heat transferred to the heat dissipation member 15 from being transferred to the housing body 14. The sealer 17 may function as an insulating member.

Examples of the sealant 17 include a sealant or sealing rubber.

The sealant may be a paint applied to the step groove 14b of the housing body 14 or the fastening body 15c of the heat dissipation member 15.

In the electronic control unit, instead of a sealant, a sealing rubber may be used.

The sealing rubber may be disposed between the step groove 14b of the housing body 14 and the fastening body 15c of the heat dissipation member 15.

The fastening member 16 may fasten the heat dissipation member 15, the sealant 17, and the housing body 14.

If the sealer 17 is a sealant, after the sealant is applied, the fastening member 16 may sequentially penetrate the heat dissipation member 15 and the sealant, and fasten the housing body 14.

If the sealer 17 is a sealing rubber, after the sealing rubber is seated in the step groove 14b, the fastening member 16 can sequentially penetrate the heat dissipation member 15 and the sealing rubber, and fasten the housing body 14.

The first board 3 may be in thermal contact with the receiving body 14a, and is preferably heat-radiated by the first phase change material PCM1.

The electronic control unit may comprise a fastening member 18 that fastens the first board 3 to the housing body 14.

The first board 3 is preferably fastened in close contact with the receiving body 14a of the housing body 14.

The fastening member 18 may pass through a through hole 32 formed in the first board 3 and be fastened to a fastening hole 14d formed in the housing body 14. The fastening hole 14d of the housing body 14 may be formed in the receiving body 14a.

An example of the fastening member 18 may be a screw with a head 18a protruding from the lower portion.

The electronic control unit may comprise a spring 19 disposed between the fastening member 18 and the first board 3.

An example of the spring 19 may be a coil spring.

The lower end of the spring 19 may be disposed on the head 18a of the fastening member 18, and the upper end of the spring 19 may support the lower surface of the first board 3.

The spring 19 may press the first board 3 upward and press the first board 3 against the housing 1.

The first board 3 may be pressed against the housing body 14, particularly the receiving body 14a by the spring 19.

When the first phase change material PCM1 is accommodated in the housing body 14 and the heat of the first board 3 is transferred to the first phase change material PCM1, the heat of the first board 3 may be dissipated more quickly.

When the first phase change material PCM1 is accommodated in the housing body 14 and the heat of the first board 3 is transferred to the first phase change material PCM1, even if the temperature of the coolant passing through the coolant passage 21 is high, the heat of the first board 3 can be efficiently dissipated.

The electronic control unit may further comprise a second board 4, a third board 5, and a control board 6.

A second semiconductor element 41 may be mounted on the second board 4. The second semiconductor element 41 may be mounted on the upper surface of the second board 4.

The second semiconductor element 41 may be in thermal contact with the lower surface 2b of the cooling jacket 2, and heat from the second semiconductor element 41 may be transferred to the lower surface 2b of the cooling jacket 2.

One example of the second semiconductor element 41 may be in direct contact with the lower surface 2b of the cooling jacket 2.

The other example of the second semiconductor element 41 may be in contact with the lower surface 2b of the cooling jacket 2 via a second thermal interface material. A second thermal interface material may be disposed between the upper surface of the second semiconductor element 41 and the lower surface 2b of the cooling jacket 2.

An example of the second semiconductor element 41 may be a system-on-chip (SoC) mounted on the second board 4.

An example of the second semiconductor element 41 may be a semiconductor chip for autonomous driving of a vehicle.

The second semiconductor element 41 may be in thermal contact with the lower cover 24 of the cooling jacket 2.

The second board 4 may be fastened to the cooling jacket 2 or the frame 13. The first board 2 may be fastened to the cooling jacket 2 or the frame 13 using a fastening member 43, such as a screw.

The second board 4 may be connected to the control board 6 via a connector. An example of the connector may be a B2B connector having a male and a female connector.

The second board 4 may be connected to the control board 6 via the first connector 44.

A third semiconductor element 51 may be mounted on the third board 5. The third semiconductor element 51 may be mounted on the upper surface of the third board 5.

The third semiconductor element 51 may be in thermal contact with the lower surface 2b of the cooling jacket 2, and heat from the third semiconductor element 51 may be transferred to the lower surface 2b of the cooling jacket 2.

One example of the third semiconductor element 51 may be in direct contact with the lower surface 2b of the cooling jacket 2.

The other example of the third semiconductor element 51 may be in contact with the lower surface 2b of the cooling jacket 2 via a third thermal interface material. A third thermal interface material may be disposed between the upper surface of the third semiconductor element 51 and the lower surface 2b of the cooling jacket 2.

An example of the third semiconductor element 51 may be a system-on-chip (SoC) mounted on the third board 5.

An example of the third semiconductor element 51 may be a semiconductor chip for autonomous driving of a vehicle.

The third semiconductor element 51 may be in thermal contact with the lower cover 24 of the cooling jacket 2.

The third board 5 may be fastened to the cooling jacket 2 or the frame 13. The third board 5 may be fastened to the cooling jacket 2 or the frame 13 using a fastening member 53, such as a screw.

The third board 5 may be connected to the control board 6 via a connector. An example of the connector may be a B2B connector having male and female ends.

The third board 5 can be connected to the control board 6 via a second connector 54.

The second semiconductor element 41 and the third semiconductor element 51 are CPUs of the same specifications, and can be divided into a primary node and a secondary node to perform the same function. Even if a hardware failure occurs in one node, they can back up each other to ensure normal functioning.

The third board 5 may be parallel to the second board 4. The third board 5 may be spaced apart from the second board 4 in the horizontal direction X.

The heat generation of the second semiconductor element 41 and the heat generation of the third semiconductor element 51 may be relatively smaller than the heat generation of the neural network processing unit.

It is desirable to balance the heat transfer between the upper surface 2a and the lower surface 2b of the cooling jacket 2.

When the second semiconductor element 41 and the third semiconductor element 51 are in thermal contact with the lower surface 2b of the cooling jacket 2, the first semiconductor element 31 may be in thermal contact with the upper surface 2a of the cooling jacket 2.

Conversely, when the second semiconductor element 41 and the third semiconductor element 51 are in thermal contact with the upper surface 2a of the cooling jacket 2, the first semiconductor element 31 may be in thermal contact with the lower surface 2b of the cooling jacket 2.

The first semiconductor element 31 may be spaced apart from the second semiconductor element 41 or the second semiconductor element 51 with the cooling jacket 2 interposed therebetween.

The first semiconductor element 31 may be spaced apart from one of the second semiconductor element 41 and the third semiconductor element 51 in the vertical direction Z. Hereinafter, the first semiconductor element 51 will be described as being spaced apart from the third semiconductor element 51 in the vertical direction Z. The first semiconductor element 31 may be horizontally biased on the upper surface 2a of the cooling jacket 2.

That is, the upper surface 2a of the cooling jacket 2 may be a heat-absorbing surface that absorbs heat from the first semiconductor element 31, and the lower surface 2b of the cooling jacket 2 may be a heat-absorbing surface that absorbs heat from the second semiconductor element 41 and heat from the third semiconductor element 51.

The cooling jacket 2 may be formed with a second space V3 partitioned from the coolant passage 21.

A second phase change material PCM2 may be accommodated in the second space V3.

The cooling jacket 2 may be formed with a third space V4 partitioned from the coolant passage 21 and the second space S.

A third phase change material PCM2 may be accommodated in the third space V4.

The second space V3 and the third space V4 may each be formed on the lower surface of the cooling plate 22. Each of the second space V3 and the third space V4 may be formed by being recessed into the lower surface of the cooling plate 22.

The lower cover 24 may cover the second space V3 and the third space V4 from the lower side of the cooling plate 22.

The second space V3 may be formed on the upper surface of the second board 4.

The lower cover 24 may comprise a first heat transfer unit disposed between the second board 4 and the second space V3, and heat from the second semiconductor element 41 may be transferred to the second phase change material PCM2 through the first heat transfer unit.

The second phase change material PCM2 may be a material that accumulates a large amount of heat energy or releases stored heat energy through a phase change process.

As the temperature of the second phase change material PCM2 increases, it reaches its melting point and absorbs a certain amount of heat, known as the melting enthalpy, as it changes from a solid state to a liquid state.

The lower cover 24 may be a phase change material cover that blocks the second phase change material PCM2 from the lower side of the second space V3.

The heat of the second board 4 may be transferred to the second phase change material PCM2 through the lower cover 24, and the second phase change material PCM2 may change its phase from a solid state to a liquid state due to the heat transferred from the second board 4 and can absorb the heat released from the second board 4.

The second phase change material PCM2 can release heat as it changes its phase from a liquid state to a solid state. The heat released from the second phase change material PCM2 can be transferred to the cooling plate 22, and the cooling plate 22 may dissipate the transferred heat to coolant flowing through the coolant channel 21.

The third space V4 may be located above the third board 5.

The lower cover 24 may comprise a second heat transfer unit disposed between the third board 4 and the third space V4, and heat from the third semiconductor element 51 may be transferred to the third phase change material PCM3 through the second heat transfer unit.

The third phase change material PCM3 may be a material that accumulates a large amount of heat energy or releases stored heat energy through a phase change process.

As the temperature of the third phase change material PCM3 increases, it reaches its melting point and can absorb a certain amount of heat, known as the melting enthalpy, as it changes from a solid state to a liquid state.

The lower cover 24 may be a phase change material cover that blocks the third phase change material PCM3 from the lower side of the third space V4.

Heat from the third board 5 may be transferred to the third phase change material PCM3 through the lower cover 24. The third phase change material PCM3 can change its phase from a solid state to a liquid state due to the heat transferred from the third board 5 and may absorb heat released from the third board 5.

The third phase change material PCM3 may release heat as it changes its phase from a liquid state to a solid state. The heat released from the third phase change material PCM3 may be transferred to the cooling plate 22, and the cooling plate 22 may dissipate the transferred heat to coolant flowing through the coolant channel 21.

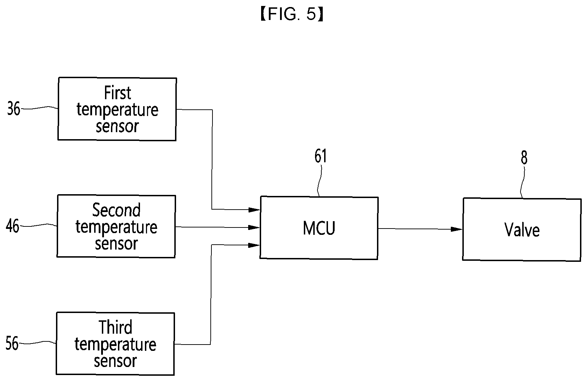

The control board 6 may be equipped with a controller that controls the overall operation of the electronic control unit. An example of the controller may be a micro controller unit 61 MCU, refer to FIG. 5.

The control board 6 may be a backplane board.

The control board 6 may be in thermal contact with the cooling jacket 2.

The control board 6 may be fastened to a control board fastening portion 2d formed on the cooling jacket 2 or frame 13 using a fastening member 62, such as a screw.

The control board 6 may be in thermal contact with the lower housing 12.

The control board 6 may be fastened to the lower housing 12.

The control board 6 may be fastened to the lower housing 12 using a fastening member 63, such as a screw.

The control board 6 may be connected to the first board 3 via a harness cable 64.

The upper surface of the control board 6 may face the lower surface of the second board 4 and the lower surface of the third board 5 in the vertical direction Z.

The control board 6 may be spaced apart from the second board 4 in the vertical direction Z.

The control board 6 may be connected to the second board 4 via a first connector 44.

The control board 6 may be spaced apart from the third board 5 in the vertical direction Z.

The control board 6 can be connected to the third board 5 via a second connector 54.

The electronic control unit may further comprise a valve 8.

The valve 8 can close or open the coolant passage 21.

An example of the valve 8 may be an electric valve and may include a motor. An example of the valve 8 may be a motorized valve.

The valve 8 may be disposed in the cooling jacket 2 and may close or open the coolant inlet 25.

The valve 8 may be controlled by a controller.

The valve 8 may be controlled in either an open or closed mode by a micro control unit 61.

When the valve 8 is in the open mode, the valve 8 may open the coolant inlet 25, allowing coolant to flow into the coolant passage 21.

When the valve 8 is in the closed mode, the valve 8 may be closed to block the coolant inlet 25, and coolant may not flow into the coolant passage 21.

The valve 8 may receive a signal from the micro control unit 61 and actively control the flow rate so that the junction temperature, which varies depending on the operating rate of the semiconductor element, does not exceed the allowable temperature Max Tj of the semiconductor element. Here, the junction temperature may be defined as the highest temperature of the semiconductor element, and may be the temperature output from a temperature sensor installed in the semiconductor element.

When the valve 8 is in open mode, the heat of the first semiconductor element 31, the heat of the second semiconductor element 41, and the heat of the third semiconductor element 51 may be dissipated by the coolant flowing in the coolant passage 21, and the first semiconductor element 31, the second semiconductor element 41, and the third semiconductor element 51 may be dissipated by coolant.

When the valve 8 is in closed mode, the valve 8 can be closed to block the coolant inlet 25, and the coolant cannot flow into the coolant passage 21.

The heat of the first semiconductor element 31 can be absorbed by the first phase change material PCM1, the heat of the second semiconductor element 41 can be absorbed by the second phase change material PCM2, and the heat of the third semiconductor element 51 can be absorbed by the third phase change material PCM4.

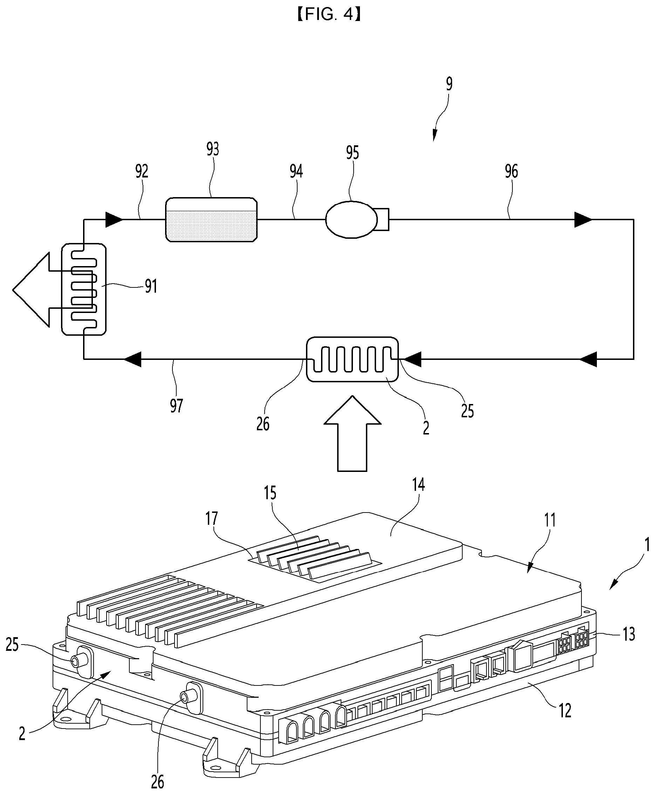

The valve 8 can operate depending on the failure type of the water-cooled loop system 9, refer to FIG. 4 connected to the cooling jacket 2. The water-cooled loop system 9 will be described later with reference to FIG. 4.

FIG. 4 is a view illustrating an example of an electronic control unit according to the present embodiment when cooled by a water-cooled loop system,

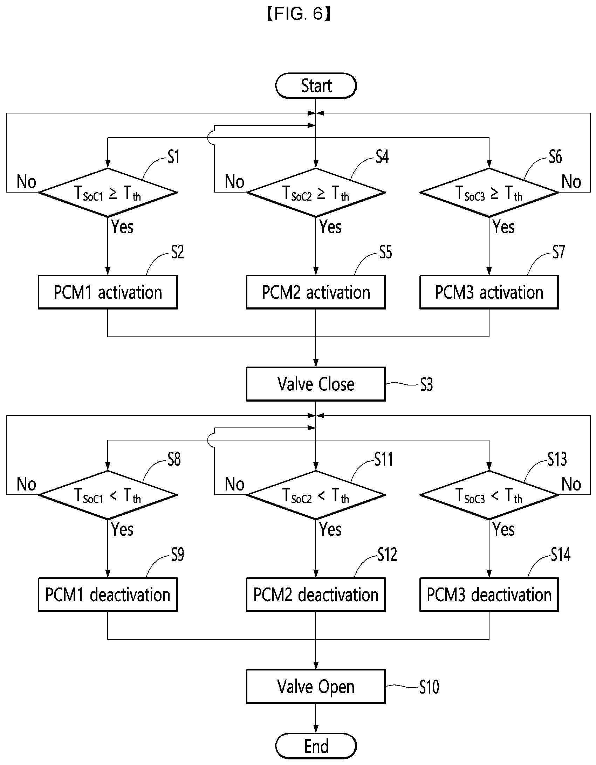

FIG. 5 is a control block view of an example of an electronic control unit according to the present embodiment, and FIG. 6 is a flowchart of an example of an electronic control unit according to the present embodiment.

A water-cooled loop system 9 may comprise a heat exchanger 91, a coolant tank 93 connected to the heat exchanger 91 via a heat exchanger outlet pipe 92, a pump 95 connected to the coolant tank 93 via a pump inlet pipe 94, and a pump outlet pipe 96 connecting the pump 95 to an electronic control unit. The electronic control unit and the heat exchanger 91 may be connected via a heat exchanger inlet pipe 97.

The heat exchanger 91 may dissipate heat from the coolant to the atmosphere through air cooling. An example of the heat exchanger 91 may be a radiator.

The pump outlet pipe 96 may be connected to the coolant inlet 25 of the cooling jacket 2.

The heat exchanger inlet pipe 97 may be connected to the coolant outlet 26 of the cooling jacket 2.

Coolant can circulate through the heat exchanger 91 and the cooling jacket 2, and can dissipate heat to the electronic control unit.

The water-cooled loop system 9 may include a temperature sensor, a flow sensor, or a flow rate sensor.

The temperature sensor, flow sensor, or flow rate sensor may transmit sensing values to the micro control unit 61, and the micro control unit 61 may control the valve 8 to open or close mode based on the sensing values.

The water-cooled loop system 9 may experience no coolant flow due to a failure of the pump 95, or the flow rate of the water-cooled loop system 9 may be 0 m3/hr or the flow rate of the water-cooled loop system 9 may be 0 m/s.

The water-cooled loop system 9 may experience a rise in coolant temperature due to a failure of the heat exchanger 91.

Meanwhile, if normal coolant flows into the coolant inlet 25 of the cooling jacket 2 and normal coolant flows out of the coolant outlet 26 of the cooling jacket 2, the junction temperature of the first semiconductor element 31, the junction temperature of the second semiconductor element 41, and the junction temperature of the third semiconductor element 51 may be within normal ranges.

However, if normal coolant fails to flow into the coolant inlet 25 of the cooling jacket 2 due to a failure of the heat exchanger 91 or pump 95, the temperature of the semiconductor element may rapidly increase, reach a temperature limit, and cause the semiconductor element to thermally shut down.

Each of the first semiconductor element 31, the second semiconductor element 41, and the third semiconductor element 51 may include a temperature sensor.

The first semiconductor element 31 may comprise a first temperature sensor 36, the second semiconductor element 41 may comprise a second temperature sensor 46, and the third semiconductor element 51 may comprise a third temperature sensor 56.

The first temperature sensor 36 may be provided within the first semiconductor element 31 and may measure the junction temperature of the first semiconductor element 31.

The second temperature sensor 46 may be provided within the second semiconductor element 41 and may measure the junction temperature of the second semiconductor element 41.

The third temperature sensor 56 may be provided within the third semiconductor element 51 and may measure the junction temperature of the third semiconductor element 51.

The electronic control unit may further include a micro control unit 61.

The micro control unit 61 can compare the temperature input from the temperature sensor with the set temperature in real time, and if the temperature input from the temperature sensor is higher than the set temperature, the valve 8 can be controlled in a closed mode to block the coolant inlet 25, thereby preventing high-temperature coolant from flowing into the cooling jacket 2 due to a failure of the heat exchanger 91.

That is, the micro control unit 61 may close or open the valve 8 based on the sensing values of the first temperature sensor 36, the second temperature sensor 46, and the third temperature sensor 56.

The micro control unit 61 may control the valve 8 to close mode if the temperature Tsoc1 sensed by the first temperature sensor 36 is higher than the first set temperature Tth. (S1) (S2) (S3)

The first set temperature Tth may be set lower than the critical temperature of the first semiconductor element 31. For example, if the critical temperature of the first semiconductor element 31 is 125°C, the first set temperature Tth may be 120°C or 110°C.

The heat of the first semiconductor element 31 may be transferred to the first phase change material PCM1 through the receiving body 14a. When the temperature of the first phase change material PCM1 reaches the phase change temperature, the first phase change material PCM1 may be activated from a solid state to a liquid state, and the amount of heat absorbed can increase due to the latent heat effect. The first phase change material PCM1 may rapidly absorb heat from the first semiconductor element 31.

When the valve 8 is controlled in the closed mode, the valve 8 can be closed to prevent coolant from flowing into the coolant inlet 25. (S3)

When the valve 8 is in the closed mode, coolant, whose temperature has increased due to a failure of the heat exchanger 91, can no longer flow into the coolant passage 21 of the cooling jacket 2. The cooling jacket 2 does not interfere with the heat absorption of the first phase change material PCM1, and the first phase change material PCM1 may dissipate heat from the first semiconductor element 31 without overheating the first semiconductor element 31.

The micro control unit 61 can control the valve 8 in the closed mode when the temperature Tsoc2 sensed by the second temperature sensor 46 is higher than the second set temperature Tth. (S4)(S5)(S3)

The second set temperature Tth may be set lower than the critical temperature of the second semiconductor element 41. For example, if the critical temperature of the second semiconductor element 41 is 125°C, the second set temperature Tth may be 120°C or 110°C.

The second set temperature Tth may be set to be the same as or different from the first set temperature.

The heat of the second semiconductor element 41 may be transferred to the second phase change material PCM2 through the cooling jacket 2. When the temperature of the second phase change material PCM2 reaches the phase change temperature, the second phase change material PCM2 may be activated from a solid state to a liquid state, and the amount of heat absorbed may increase due to the latent heat effect. The second phase change material PCM2 may rapidly absorb heat from the second semiconductor element 41.

When the valve 8 is controlled in the closed mode, the valve 8 may be closed to prevent the coolant from flowing into the coolant inlet 25. (S3)

When the valve 8 is in the closed mode, the coolant, whose temperature has increased due to a failure of the heat exchanger 91, can no longer flow into the coolant passage 21 of the cooling jacket 2, and the cooling jacket 2 may dissipate heat from the second semiconductor element 41 without hindering the heat absorption of the second phase change material PCM2, and the second phase change material PCM2 can prevent the second semiconductor element 41 from overheating.

The micro control unit 61 can control the valve 8 in the closed mode to close the coolant inlet when the temperature Tsoc3 sensed by the third temperature sensor 56 is higher than the third set temperature Tth. (S6)(S7)(S3)

The third set temperature Tth may be set lower than the critical temperature of the third semiconductor element 51. For example, if the critical temperature of the third semiconductor element 51 is 125°C, the third set temperature Tth may be 120°C or 110°C.

The third set temperature Tth may be set to be the same as the second set temperature.

The third set temperature Tth may be set to be the same as or different from the first set temperature.

The heat of the third semiconductor element 51 may be transferred to the third phase change material PCM3 through the cooling jacket 2. When the temperature of the third phase change material PCM3 reaches the phase change temperature, the third phase change material PCM3 may be activated from a solid state to a liquid state, and the amount of heat absorbed may increase due to the latent heat effect. The third phase change material PCM3 may rapidly absorb heat from the third semiconductor element 41.

When the valve 8 is controlled in the closed mode, the valve 8 can be closed to prevent coolant from flowing into the coolant inlet 25. (S3)

When the valve 8 is in the closed mode, coolant whose temperature has increased due to a failure of the heat exchanger 91 can no longer flow into the coolant path 21 of the cooling jacket 2, and the cooling jacket 2 can dissipate heat from the third semiconductor element 51 without hindering the heat absorption of the third phase change material PCM3, and the third phase change material PCM3 can prevent the third semiconductor element 51 from overheating.

The micro control unit 61 may control the valve 8 in open mode if the temperature Tsoc1 sensed by the first temperature sensor 36 is less than the first set temperature Tth. (S8)(S9)(S10)

The micro control unit 61 may control the valve 8 in open mode if the temperature Tsoc2 sensed by the second temperature sensor 46 is less than the second set temperature Tth. (S11)(S12)(S10)

The micro control unit 61 may control the valve 8 in open mode if the temperature Tsoc3 sensed by the third temperature sensor 56 is less than the third set temperature Tth. (S13)(S14)(S10)

The micro control unit 61 may control the valve 8 in open mode if the temperature Tsoc1 sensed by the first temperature sensor 36 is less than the first set temperature Tth and the second If the temperature Tsoc2 sensed by the temperature sensor 46 is less than the second set temperature Tth and the temperature Tsoc3 sensed by the third temperature sensor 56 is less than the third set temperature Tth, the valve 8 may be controlled in an open mode.

When the valve 8 is controlled in an open mode, the valve 8 may be opened to allow coolant to flow into the coolant inlet 25. (S10)

The first phase change material PCM1 may be deactivated from a liquid state to a solid state, and the first phase change material PCM1 may rapidly dissipate heat to the coolant flowing in the coolant passage 21.

The second phase change material PCM2 may be deactivated from a liquid state to a solid state, and the second phase change material PCM2 may rapidly dissipate heat to the coolant flowing in the coolant passage 21.

The third phase change material PCM3 can be deactivated from a liquid state to a solid state, and the third phase change material PCM3 can rapidly dissipate heat to the coolant flowing in the coolant channel 21.

An example of an electronic control unit can also control the valve 8 in closed mode based on the sensing values of a temperature sensor, a flow sensor, or a flow rate sensor in the water-cooled loop system 9.

An example of an electronic control unit can also control the valve 8 in closed mode, closing the coolant inlet 25, if the temperature sensed by the temperature sensor is above a set temperature.

An example of an electronic control unit can also control the valve 8 in closed mode if the flow rate sensed by the flow rate sensor is below a set flow rate.

An example of an electronic control unit can also control the valve 8 in closed mode if the flow rate sensed by the flow rate sensor is below a set flow rate.

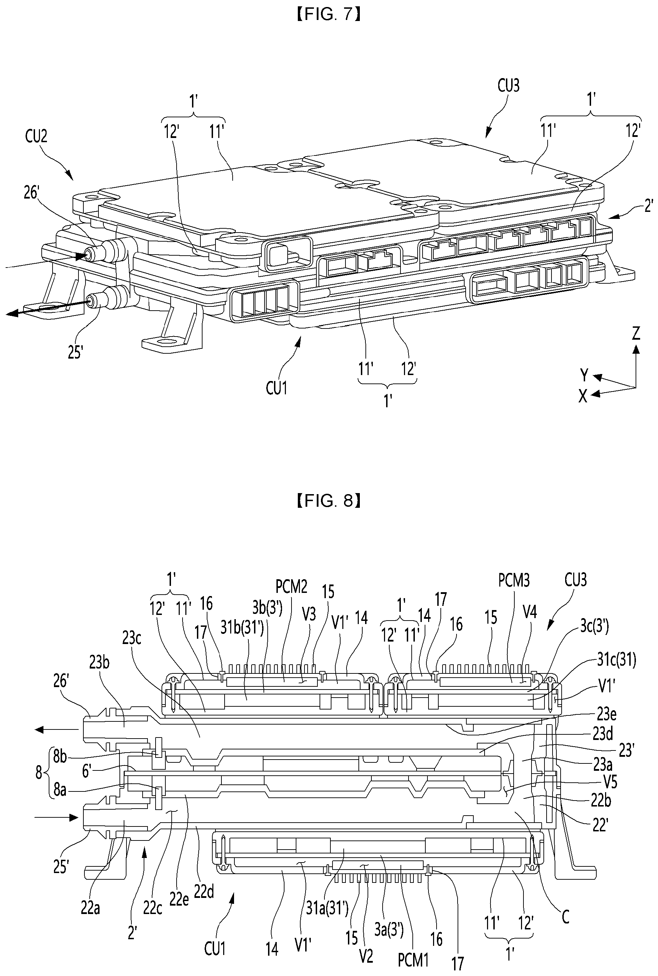

FIG. 7 is a perspective view of the other example of an electronic control unit according to the present embodiment, and FIG. 8 is a view illustrating the interior of the other example of an electronic control unit according to the present embodiment.

The other example of an electronic control unit includes at least one control unit and a cooling jacket 2'.

The control unit may include a housing 1' and a board 3' accommodated within the housing 1'.

A semiconductor element 31' may be mounted on the board 3'. The semiconductor element 31' may be in thermal contact with at least one of the housing 1' and the cooling jacket 2'.

The housing 1' may comprise an upper housing 11' and a lower housing 12'.

Either the upper housing 11' or the lower housing 12' may be in thermal contact with the semiconductor element 31', and the other of the upper housing 11' or the lower housing 12' may be in thermal contact with the board 3'.

An inner space V1' may be formed inside the housing 1'. The inner space V1' may be formed between the upper housing 11' and the lower housing 12'.

The board 3' may be accommodated in the inner space V1'.

The semiconductor element 31' may be mounted on one of the upper and lower surfaces of the board 3'.

The board 3' may be in thermal contact with either the upper housing 11' or the lower housing 12', and the semiconductor element 31' may be in thermal contact with the other of the upper housing 11' and the lower housing 12'.

When the semiconductor element 31' is mounted on the lower surface of the board 3', the semiconductor element 31' may be in thermal contact with the lower housing 12', and the board 3 may be in thermal contact with the upper housing 11'.

When the semiconductor element 31' is in thermal contact with the lower housing 12', the board 3' may be in thermal contact with the upper housing 11', and a phase change material may be accommodated in the upper housing 11'.

In this case, the phase change material may be activated by heat transferred from the board 3'. When the temperature of the phase change material increases due to the heat transferred from the board 3', the phase change material can reach its melting point and absorb a certain amount of heat, known as the enthalpy of fusion, as it changes from a solid state to a liquid state.

The phase change material can release heat and become inactive as it changes from a liquid state to a solid state. The heat released from the phase change material can be transferred to the upper housing 11', and the upper housing 11' may dissipate the heat by air cooling.

When the semiconductor element 31' is mounted on the upper surface of the board 3', the semiconductor element 31' may be in thermal contact with the upper housing 11', and the board 3' may be in thermal contact with the lower housing 12'.

When the semiconductor element 31' is in thermal contact with the upper housing 11', the board 3' can be in thermal contact with the lower housing 12'. The phase change material can be in thermal contact with the housing 12', and the lower housing 12' can accommodate a phase change material.

In this case, the phase change material can be activated by heat transferred from the board 3'. When the temperature of the phase change material increases due to the heat transferred from the board 3', the phase change material can reach its melting point and absorb a certain amount of heat, known as the enthalpy of fusion, as it changes from a solid state to a liquid state.

The phase change material can release heat and become inactive as it changes from a liquid state to a solid state. The heat released from the phase change material may be transferred to the lower housing 12', and the lower housing 12' may dissipate the heat by air cooling.

The housing 1' and the board 3' can form a control unit.

A cooling jacket 2' may be disposed outside the housing 1'. The cooling jacket 2' may be disposed outside the housing 1' to cool the first semiconductor element. The cooling jacket 2' may be an outer cooling jacket that cools the element 31'.

The cooling jacket 2' may comprise a lower coolant jacket 22' and an upper coolant jacket 23'.

The cooling jacket 2' may be provided with a coolant inlet 25' that guides coolant C into the interior of the cooling jacket 2'.

The cooling jacket 2' may be provided with a coolant outlet 26' that guides coolant that has passed through the interior of the cooling jacket 2'.

The coolant inlet 25' may be provided in either the lower coolant jacket 22' or the upper coolant jacket 23'.

The coolant outlet 26' may be provided in the other of the lower coolant jacket 22' or the upper coolant jacket 23'.

The lower coolant jacket 22' may comprise a first passage 22a and a second passage 22b spaced apart from the first passage 22a may be formed.

A lower coolant passage 22c through which coolant, such as water, passes may be formed inside the lower coolant jacket 22'.

The lower coolant passage 22c may be formed between the first passage 22a and the second passage 22b.

The lower coolant jacket 22' may comprise a lower plate 22d and an upper plate 22e, and the lower coolant passage 22c may be formed between the lower plate 22d and the upper plate 22e.

The upper coolant jacket 23' may comprise a third passage 23a and a fourth passage 23b spaced apart from the third passage 23a.

An upper coolant passage 23c through which coolant, such as water, passes may be formed inside the upper coolant jacket 23'.

The upper coolant passage 23c may be formed between the third passage 23a and the fourth passage 23b.

The upper coolant jacket 23' may comprise a lower plate 23d and an upper plate 23e, and an upper coolant passage 23b may be formed between the lower plate 23d and the upper plate 23e.

A valve 8 for opening and closing the coolant passage may be arranged in at least one of the lower coolant jacket 22' and the upper coolant jacket 23'. A plurality of valves 8 may be provided. The plurality of valves 8a8b may comprise a lower valve 8a and an upper valve 8b.

The lower valve 8a that opens and closes at least one of the first passage 22a or the lower coolant passages 22c may be disposed in the lower coolant jacket 22'

An example of the lower valve 8a may be an electric valve and may include a motor. An example of the lower valve 8a may be a motorized valve.

The upper valve 8a that opens and closes at least one of the fourth passage 23b or the upper coolant passages 23c may be disposed in the upper coolant jacket 23'.

An example of the upper valve 8b may be an electric valve and may include a motor. An example of the upper valve 8b may be a motorized valve.

The third passage 23a may be connected to the second passage 22b.

Coolant flowing into the first passage 22a may flow into the second passage 22b after passing through the lower coolant passage 22c, and then It can flow to the upper coolant passage 23c through the third passage 23a, and after passing through the upper coolant passage 23c, it can pass through the fourth passage 23b.

A center space V5 may be formed between the upper plate 22e of the lower coolant jacket 22' and the lower plate 23d of the upper coolant jacket 23'.

A control board 6' can be accommodated in the center space V5.

The upper plate 22e of the lower coolant jacket 22' or the lower plate 23d of the upper coolant jacket 23' may be in thermal contact with the control board 6'.

A contact portion that makes contact with the control board 6' may be formed on the upper plate 22e of the lower coolant jacket 22' or the lower plate 23d of the upper coolant jacket 23'.

A micro control unit 61' may be disposed on the control board 6'.

The control board 6' may be an autonomous driving control board for executing Level 1 or Level 2 among autonomous driving levels.

The assembly of the cooling jacket 2' and the control board 6' may constitute a control unit. The assembly of the cooling jacket 2' and the control board 6' may be an autonomous driving control unit for executing Level 1 or Level 2 among autonomous driving levels.

The other example of an electronic control unit may comprise multiple control units.

A plurality of control units may comprise a lower control unit disposed on the lower surface of the cooling jacket 2' and an upper control unit disposed on the upper surface of the cooling jacket 2'.

At least one of the upper control unit and the lower control unit may be provided in multiple numbers.

A plurality of control units may comprise a lower control unit CU1 disposed on the lower surface of the cooling jacket 2'. and a pair of upper control units CU2 CU3 disposed on the upper surface of the cooling jacket 2'.

The pair of upper control units CU2 CU3 include a first upper control unit CU2 and a second upper control unit CU3.

Each of the lower control unit CU1, the first upper control unit CU2, and the second upper control unit CU3 may comprise a housing 1' and a board 3' on which a semiconductor element 31' is mounted.

Hereinafter, the board 3' of the lower control unit CU1 is referred to as a first board 3a, and the semiconductor element 31' mounted on the first board 3a is referred to as a first semiconductor element 31a.

The lower control unit CU1 may be an autonomous driving control unit for executing Level 2+ among autonomous driving levels, or an infotainment control unit capable of executing infotainment (software or media that adds entertainment to the transmission of information).

The housing 1' of the lower control unit CU1 may comprise a housing body 14 with a first board 3a in thermal contact and a first space V2 formed therein; and a heat dissipation member 15 that covers the first space V2 and has heat dissipation fins formed therein.

A first phase change material PCM1 may be accommodated in the first space V2.

The housing 1' of the lower control unit CU1 comprises an upper housing 11' and a lower housing 12'.

The upper housing 11' may be disposed above the lower housing 12'.

The first semiconductor element 31a may be in thermal contact with the upper housing 11'.

The lower housing 12' may comprise a housing body 14 a heat dissipation member 15 and a sealer 17.

The housing body 14 may comprise a receiving body for receiving the first phase change material PCM1, and is identical or similar to the housing body 14 of an example electronic control unit. Therefore, to avoid redundant description, the same reference numerals will be used, and a description thereof will be omitted.

The heat dissipation member 15 may cover the first space V2 and dissipate heat to the outside. The heat dissipation member 15 may be fastened to the housing body 14 by a fastening member 16. Since the heat dissipation member 15 is identical or similar to the heat dissipation member 15 of an example electronic control unit, the same reference numerals will be used, and a description thereof will be omitted.

The sealer 17 may be disposed between the housing body 14 and the heat dissipation member 15, and may prevent heat transferred to the heat dissipation member 15 from being transferred to the housing body 14. Since it is identical or similar to the sealer 17 of the electronic control unit, for example, the same reference numeral is used to avoid redundant description, and a description thereof is omitted.

Hereinafter, the board 3' of the first upper control unit CU2 is referred to as the second board 3b, and the semiconductor element 31' mounted on the second board 3b is referred to as the second semiconductor element 31b.

The first upper control unit CU2 may be an autonomous driving control unit for executing Level 3 among autonomous driving levels.

The housing 1' of the first upper control unit CU2 comprised a housing body 14 in which the second board 3b is in thermal contact and a second space V3 is formed; And it may include a heat dissipation member 15 that covers the second space V3 and has heat dissipation fins formed thereon.

A second phase change material PCM2 may be accommodated in the second space V3.

The housing 1' of the first upper control unit CU2 comprises an upper housing 11' and a lower housing 12'.

The upper housing 11' may be disposed above the lower housing 12'.

The upper housing 11' may comprise a housing body 14; a heat dissipation member 15, and a sealer 17.

The housing body 14 may comprise a receiving body that accommodates the second phase change material PCM2, and is identical or similar to the housing body 14 of an example electronic control unit. Therefore, to avoid redundant description, the same reference numerals are used, and a description thereof is omitted.

The heat dissipation member 15 may cover the second space V3 and dissipate heat to the outside. The heat dissipation member 15 can be fastened to the housing body 14 by a fastening member 16. Since it is identical or similar to the heat dissipation member 15 of an example electronic control unit, the same reference numeral is used to avoid redundant description, and its description is omitted.

The sealer 17 may be disposed between the housing body 14 and the heat dissipation member 15 and can prevent heat transferred to the heat dissipation member 15 from being transferred to the housing body 14. Since it is identical or similar to the sealer 17 of an example electronic control unit, the same reference numeral is used to avoid redundant description, and its description is omitted.

The second semiconductor element 31b may be in thermal contact with the lower housing 12'.

Hereinafter, the board 3' of the second upper control unit CU3 will be referred to as the third board 3c, and the semiconductor element 31' mounted on the third board 3c will be referred to as the third semiconductor element 31c.

The second upper control unit CU3 may be an autonomous driving control unit for executing Level 4 of autonomous driving.

The housing 1' of the second upper control unit CU3 may comprise a housing body 14 with which the third board 3c is thermally contacted and a third space V4 is formed; and a heat dissipation member 15 that covers the third space V4 and has heat dissipation fins formed therein.

The third space V4 may accommodate a third phase change material PCM3.

The housing 1' of the second upper control unit CU3 comprises an upper housing 11' and a lower housing 12'.

The upper housing 11' may be disposed above the lower housing 12'.

The upper housing 11' may comprise a housing body 14; a heat dissipation member 15, and a sealer 17.

The housing body 14 may comprise a housing body that accommodates a third phase change material PCM3. Since it is identical or similar to the housing body 14 of an example electronic control unit, the same reference numerals will be used and a description thereof will be omitted to avoid redundant description.

The heat dissipation member 15 may cover the third space V4 and dissipate heat to the outside. The heat dissipation member 15 may be fastened to the housing body 14 by a fastening member 16. Since it is identical or similar to the heat dissipation member 15 of an example electronic control unit, the same reference numerals will be used and a description thereof will be omitted to avoid redundant description.

The sealer 17 can be placed between the housing body 14 and the heat dissipation member 15, and can prevent heat transferred to the heat dissipation member 15 from being transferred to the housing body 14. Since it is the same as or similar to the sealer 17 of an electronic control unit, the same reference numeral is used to avoid redundant description, and the description thereof is omitted.

The third semiconductor element 31c can be in thermal contact with the lower housing 12'.

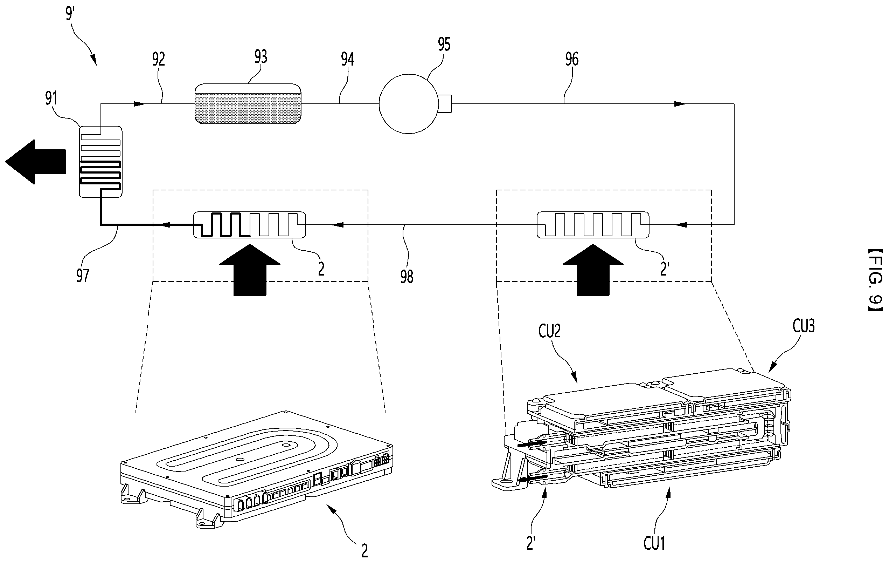

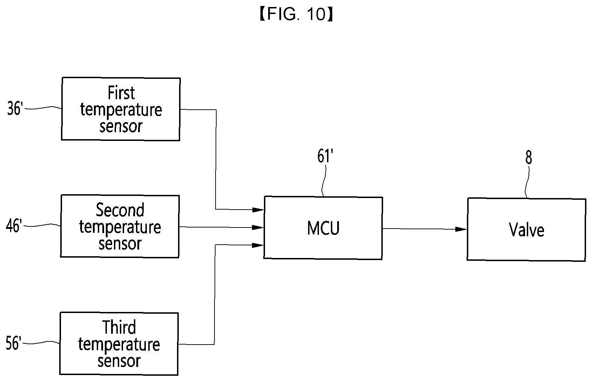

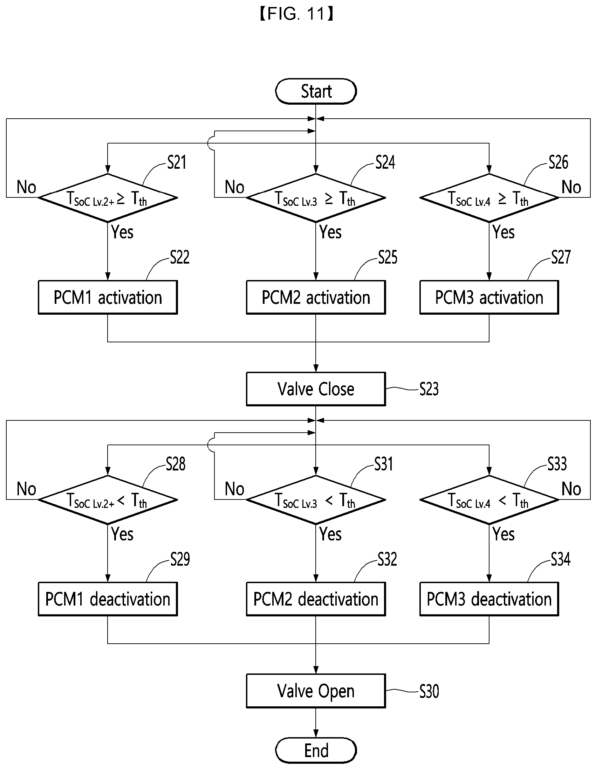

FIG. 9 is a view illustrating the other example of an electronic control unit according to the present embodiment when cooled by a water-cooled loop system, FIG. 10 is a control block view of the other example of an electronic control unit according to the present embodiment, and FIG. 11 is a flowchart of the other example of an electronic control unit according to the present embodiment.

The water-cooled loop system 9' may comprise a heat exchanger 91, a coolant tank 93 connected to the heat exchanger 91 via a heat exchanger outlet pipe 92, a pump 95 connected to the coolant tank 93 via a pump inlet pipe 94, and a pump outlet pipe 96 connecting the pump 95 to a cooling jacket 2' of the other example of an electronic control unit, and the cooling jacket 2 of an example of an electronic control unit and the heat exchanger 91 may be connected via a heat exchanger inlet pipe 97.

The cooling jacket 2' of the other example of an electronic control unit and the cooling jacket 2 of an example of an electronic control unit may be connected via a cooling jacket connection pipe 98.

In the water-cooled loop system 9' illustrated in FIG. 9, the same components as the water-cooled loop system 9 illustrated in FIG. 4 are designated by the same reference numerals to avoid redundant descriptions, and their descriptions are omitted.

The first semiconductor element 31a, the second semiconductor element 31b, and the third semiconductor element 31c may each comprise a temperature sensor.

The first semiconductor element 31a may comprise a first temperature sensor 36', the second semiconductor element 31b may comprise a second temperature sensor 46', and the third semiconductor element 31c may comprise a third temperature sensor 56'.

The first temperature sensor 36' may be provided within the first semiconductor element 31a and may measure the junction temperature of the first semiconductor element 31a.

The second temperature sensor 46' may be provided within the second semiconductor element 31b and may measure the junction temperature of the second semiconductor element 31b.

The third temperature sensor 56' may be provided within the third semiconductor element 31c and may measure the junction temperature of the third semiconductor element 31c.

The electronic control unit may further comprise a micro control unit 61'.

The micro control unit 61' can compare the temperature input from the temperature sensor with the set temperature in real time, and if the temperature input from the temperature sensor is higher than the set temperature, the valve 8 may be controlled in a closed mode to block the coolant inlet 25, thereby preventing high-temperature coolant from flowing into the cooling jacket 2' due to a failure of the heat exchanger 91.

That is, the micro control unit 61' can close or open the valve 8 according to the sensing values of the first temperature sensor 36', the second temperature sensor 46', and the third temperature sensor 56'.

The micro control unit 61' can control the valve 8 to close mode if the temperature Tsoc Lv. 2+ sensed by the first temperature sensor 36 is higher than the first set temperature Tth. (S21)(S22)(S23)

The first set temperature Tth may be set lower than the critical temperature of the first semiconductor element 31a. For example, if the critical temperature of the first semiconductor element 31a is 125°C, the first set temperature Tth may be 120°C or 110°C.

The heat of the first semiconductor element 31a can be transferred to the first phase change material PCM1 through the receiving body. When the temperature of the first phase change material PCM1 reaches the phase change temperature, the first phase change material PCM1 can be activated from a solid state to a liquid state, and the amount of heat absorbed can increase due to the latent heat effect. The first phase change material PCM1 can rapidly absorb heat from the first semiconductor element 31a.

When the valve 8 is controlled in the closed mode, the valve 8 may be closed to prevent coolant from flowing into the coolant inlet 25. (S23)

When the valve 8 is in the closed mode, coolant whose temperature has increased due to a failure of the heat exchanger 91 can no longer flow into the lower coolant passage 22c and the upper coolant passage 23c of the cooling jacket 2', and the cooling jacket 2' may dissipate heat from the first semiconductor element 31a without hindering the heat absorption of the first phase change material PCM1, and the first phase change material PCM1 may prevent the first semiconductor element 31a from overheating.

The micro control unit 61 may control the valve 8 to close mode when the temperature Tsoc Lv. 3 sensed by the second temperature sensor 46' is higher than the second set temperature Tth. (S24)(S25)(S23)

The second set temperature Tth may be a temperature set lower than the critical temperature of the second semiconductor element 31b. For example, when the critical temperature of the second semiconductor element 31b is 125°C, the second set temperature Tth may be 120°C or 110°C.

The second set temperature Tth may be set to be the same as or different from the first set temperature.

The heat of the second semiconductor element 31b may be transferred to the second phase change material PCM2 through the cooling jacket 2', and when the temperature of the second phase change material PCM2 reaches the phase change temperature, the second phase change material PCM2 may be activated from a solid state to a liquid state, and the amount of heat absorbed can increase due to the latent heat effect. The second phase change material PCM2 may uickly absorb the heat of the second semiconductor element 31b.

When the valve 8 is controlled in the closed mode, the valve 8 may closed to prevent the coolant from flowing into the coolant inlet 25. (S23)

When the valve 8 is in the closed mode, the coolant, whose temperature has increased due to a failure of the heat exchanger 91, can no longer flow into the lower coolant passage 22c and the upper coolant passage 23c of the cooling jacket 2', and the cooling jacket 2 may dissipate heat from the second phase change material PCM2 without hindering the heat absorption of the second phase change material PCM2, and the second phase change material PCM2 may dissipate heat from the second semiconductor element 31b without overheating the second semiconductor element 31b.

The micro control unit 61 may control the valve 8 in the closed mode to close the coolant inlet when the temperature Tsoc Lv. 4 sensed by the third temperature sensor 56' is higher than the third set temperature Tth. (S26)(S27)(S23)

The third set temperature Tth may be set lower than the critical temperature of the third semiconductor element 31c. For example, if the critical temperature of the third semiconductor element 31c is 125°C, the third set temperature Tth may be 120°C or 110°C.

The third set temperature Tth may be set to be the same as the second set temperature.

The third set temperature Tth may be set to be the same as or different from the first set temperature.

The heat of the third semiconductor element 31c may be transferred to the third phase change material PCM3 through the cooling jacket 2'. When the temperature of the third phase change material PCM3 reaches the phase change temperature, the third phase change material PCM3 may be activated from a solid state to a liquid state, and the amount of heat absorbed may increase due to the latent heat effect. The third phase change material PCM3 may rapidly absorb heat from the third semiconductor element 31c.

When the valve 8 is controlled in the closed mode, the valve 8 may be closed to prevent coolant from flowing into the coolant inlet 25. (S23)

When the valve 8 is in the closed mode, coolant whose temperature has increased due to a failure of the heat exchanger 91 can no longer flow into the lower coolant passage 22c and the upper coolant passage 23c of the cooling jacket 2. The cooling jacket 2' does not interfere with the heat absorption of the third phase change material PCM3, and the third phase change material PCM3 may dissipate heat from the third semiconductor element 31c without overheating the third semiconductor element 31c.

The micro control unit 61' may control the valve 8 to open mode if the temperature Tsoc Lv. 2+ sensed by the first temperature sensor 36' is lower than the first set temperature Tth. (S28)(S29)(S30)

The micro control unit 61' may control the valve 8 to open mode if the temperature Tsoc Lv. 3 sensed by the second temperature sensor 46' is lower than the second set temperature Tth. (S31)(S32)(S30)

The micro control unit 61' may control the valve 8 to open mode if the temperature Tsoc Lv. 4 sensed by the third temperature sensor 56' is lower than the third set temperature Tth. (S33)(S34)(S30)

The micro control unit 61' may control the valve 8 to open mode if the temperature Tsoc Lv. 2+ sensed by the first temperature sensor 36' is lower than the first set temperature Tth, the temperature Tsoc Lv. 3 sensed by the second temperature sensor 46 is lower than the second set temperature Tth, and the temperature Tsoc Lv. 4 sensed by the third temperature sensor 56 is lower than the third set temperature Tth.

When the valve 8 is controlled in an open mode, the valve 8 may be opened to allow coolant to flow into the coolant inlet 25. (S30)

The first phase change material PCM1 may be deactivated from a liquid state to a solid state, and the first phase change material PCM1 may quickly dissipate heat to the coolant flowing in the lower coolant passage 22c and the upper coolant passage 23c.

The second phase change material PCM2 may be deactivated from a liquid state to a solid state, and the second phase change material PCM2 may rapidly dissipate heat to the coolant flowing in the lower coolant channel 22c and the upper coolant channel 23c.

The third phase change material PCM3 may be deactivated from a liquid state to a solid state, and the third phase change material PCM3 may rapidly dissipate heat to the coolant flowing in the lower coolant channel 22c and the upper coolant channel 23c.

The other example of an electronic control unit is that it can control the valve 8 in closed mode based on the sensing values of the temperature sensor, flow sensor, or flow rate sensor of the water-cooled loop system 9'.

The other example of an electronic control unit is that it can control the valve 8 in closed mode by closing the coolant inlet 25 if the temperature sensed by the temperature sensor is above a set temperature.

The other example of an electronic control unit is that it can control the valve 8 in closed mode if the flow rate sensed by the flow rate sensor is below a set flow rate.

The other example of an electronic control unit is that it can control the valve 8 in closed mode if the flow rate sensed by the flow rate sensor is below a set flow rate.

The above description is merely an illustrative explanation of the technical idea of the present disclosure, and various modifications and variations will be possible to those skilled in the art without departing from the essential characteristics of the present disclosure.

Accordingly, the embodiments disclosed in the present disclosure are not intended to limit the technical idea of the present disclosure, but are for illustrative purposes, and the scope of the technical idea of the present disclosure is not limited by these embodiments.

The scope of protection of the present disclosure should be interpreted in accordance with the claims below, and all technical ideas within the equivalent scope should be interpreted as being comprised in the scope of rights of the present disclosure.

## Claims

1. An electronic control unit comprising;
a housing;
a cooling jacket disposed in the housing; and
a first board having a first semiconductor element mounted on the first board,
wherein the first semiconductor element is in thermal contact with at least one of the housing or the cooling jacket,
wherein the housing comprises
a housing body in thermal contact with the first board and having a first space formed in the housing body; and
a heat dissipation member configured to cover the first space and having heat dissipation fins formed on the heat dissipation member,
wherein a first phase change material is contained in the first space.

2. The electronic control unit of claim 1, wherein the housing comprises:
a lower housing; and
an upper housing disposed above the lower frame,
wherein the upper housing comprises the housing body and the heat dissipation member.

3. The electronic control unit of claim 2, further comprising;
a fastening member penetrating the first board and fastened to the housing body; and
a spring disposed between the fastening member and the first board and configured to press the first board to the housing.

4. The electronic control unit of claim 2, further comprising;
a sealer disposed between the housing body and the heat dissipation member.

5. The electronic control unit of claim 2, further comprising;
a fastening member configured to fasten the heat dissipation member, the sealer, and the housing body.

6. The electronic control unit of claim 1,
wherein the first semiconductor element is in thermal contact with an upper surface of the cooling jacket.

7. The electronic control unit of claim 5, further comprising:
a second board having a second semiconductor element mounted on the second board; the second semiconductor element in thermal contact with a lower surface of the cooling jacket; and
a third board having a third semiconductor element mounted on the third board; the third semiconductor element in thermal contact with the lower surface of the cooling jacket.

8. The electronic control unit of claim 7,
wherein the cooling jacket comprises:
a coolant passage through which coolant flows;
a second space partitioned from the coolant passage; and
a third space partitioned from the coolant passage and the second space,
wherein a second phase change material is contained in the second space,
wherein a third phase change material is contained in the third space.

9. The electronic control unit of claim 8,
wherein the cooling jacket comprises:
a coolant cover;
a cooling plate disposed below the coolant cover; and
a lower cover disposed below the cooling plate,
wherein the coolant passage is formed between the coolant cover and the cooling plate,
wherein the second space and the third space are formed on a bottom surface of the cooling plate,
wherein the lower cover is configured to cover the second space and the third space.

10. The electronic control unit of claim 9,
wherein the second semiconductor element and the third semiconductor element are in thermal contact with the lower cover.

11. The electronic control unit of claim 8, further comprising;
a valve for closing or opening the coolant passage; and
a controller configured to control the valve.

12. The electronic control unit of claim 11,
wherein the first semiconductor element comprises a first temperature sensor,
wherein the second semiconductor element comprises a second temperature sensor,
wherein the third semiconductor element comprises a third temperature sensor,
wherein the controller configured to close or open the valve based on a sensing values of the first temperature sensor, a sensing values of the second temperature sensor, and a sensing values of the third temperature sensor.

13. The electronic control unit of claim 1, wherein the cooling jacket comprises:
a lower coolant jacket having a first passage and a second passage spaced apart from the first passage, and a lower coolant passage formed between the first and second passages through which coolant passes; and
an upper coolant jacket having a third passage communicating with the second passage and a fourth passage spaced apart from the third passage, and an upper coolant passage formed between the third and fourth passages through which coolant passes;
wherein the housing is disposed on a lower surface of the lower coolant jacket or on an upper surface of the upper coolant jacket.

14. The electronic control unit of claim 13, further comprising
a control board disposed between the lower coolant jacket and the upper coolant jacket.

15. The electronic control unit of claim 13,
wherein the housing comprises a lower housing; and
an upper housing disposed above the lower housing,
wherein the first semiconductor element is in thermal contact with one of the lower housing and the upper housing,
wherein the first board is in thermal contact with the other of the lower housing and the upper housing.
